# EUROPEAN PATENT APPLICATION

(11) **EP 2 325 676 A1**
(43) Date of publication of application: **25.05.2011**
(21) Application number: 09809447.7
(22) Date of filing: 03.06.2009
(51) Int. Cl.: G02B 1/11, G03F 7/20, H01L 33/00, B23K 26/00, B23K 26/36

(54) **PATTERN-FORMING MEMBER AND METHOD OF MANUFACTURING THE SAME**

(30) Priority: 29.08.2008 JP 2008221900
(71) Applicant: FUJIFILM Corporation, Tokyo 106-8620 (JP)
(72) Inventor: USAMI, Yoshihisa, Ashigarakami-gun Kanagawa 258-8577 (JP)
(74) Representative: Klunker . Schmitt-Nilson . Hirsch
(86) International application number: PCT/JP2009/002498
(87) International publication number: WO 2010/023789

(57) **Abstract**

There are provided a patterned member which has densely arranged pits on the surface and which is easily manufactured, and a method for manufacturing such a patterned member. A patterned member includes a substrate 10, a thermally deformable heat mode photoresist layer 20 provided on the substrate 10, pits 21 formed on the photoresist layer 20. The pits 21 are arranged in line along a plurality of tracks which are substantially parallel to one another, and as viewed in a direction along which the tracks Tn extend, each pit 21 on one track is positioned at a position corresponding to a midpoint between two adjacent pits arranged on an adjacent track.

## Description

### TECHNICAL FIELD

The present invention relates to a patterned member and a method for manufacturing the patterned member.

### BACKGROUND ART

In a light emitting element such as an LED, a fluorescent lamp, an EL (electro-luminescence) element, and a plasma display, an outer sheath member of a luminous body is formed by a clear lens, a protecting film or a glass tube, and light is emitted to the outside through the surface of the outer sheath member.

In general, a refractive index of this transparent outer sheath member is much greater than the refractive index of air. Therefore, when the light is emitted to the outside from the outer sheath member, reflection occurs at an interface between the outer sheath member and the air. In some cases, according to an angle of reflection of the light, the light reflected at the interface is not emitted from the inside to the outside of the outer sheath member, and the light is converted into heat in the end. This can also be said to a light emitting surface of an LED element comprising a semiconductor.

As a technique for preventing a loss of light due to this interface reflection, there is known a method for providing a fine asperity structure on a surface such as a light emitting surface (*e.g*., see Patent Document 1). It is preferable that when such a fine asperity structure is provided on the light emitting surface to prevent reflection of light at the interface, fine asperities are formed in a dense and precipitous manner.

Further, as a method for simply and accurately forming the above fine asperity structure, as disclosed in Patent Document 2, there is known a method for forming pits by irradiating a heat reactive type material (i.e., a material which undergoes a change in shape when it is illuminated and hence heated with an electromagnetic beam) with a laser beam.
Patent Document 1: Japanese Laid-open Patent Application, Publication No. 2003-174191
Patent Document 2: Japanese Laid-open Patent Application, Publication No. 2007-216263

### SUMMARY OF INVENTION

### TECHNICAL PROBLEM

However, when a photoresist layer comprising a heat reactive type material is processed using a laser beam, heat generated by the laser beam is transferred around a portion to be processed. Therefore, if processed holes do not have the same pitch and variations present between pitches of the holes, the shapes of the holes may be distorted where holes are disposed at a smaller pitch. For this reason, it is necessary to provide a sufficient interval between lines (*i.e*., track interval), along which scanning of the laser beam is performed, in terms of margin. Namely, holes can only be formed at relatively low density.

In view of the above, the present invention seeks to provide a patterned member, which includes a plurality of densely arranged pits on its surface and which can be manufactured in a simple manner, and a method for manufacturing this patterned member.

### SOLUTION TO PROBLEM

According to the present invention which solves the aforementioned problem, there is provided a patterned member having a surface, on which a dotted pattern is formed, comprising: a substrate; a photoresist layer which is provided on the substrate and undergoes a change in shape when it is illuminated and hence heated with an electromagnetic beam; and a plurality of pits formed on the photoresist layer, wherein the plurality of pits are arranged in line along a plurality of tracks which are substantially parallel to one another, and as viewed in a direction along which the tracks extend, each pit on one track is positioned at a position corresponding to a midpoint between two adjacent pits arranged on an adjacent track.

With this configuration, since each pit on one track is positioned at a position corresponding to a midpoint between two adjacent pits arranged on an adjacent track as viewed in a direction along which the tracks extend, each of the pits can be positioned to keep the same distance from two adjacent pits arranged on an adjacent track. This can make a track interval narrower to provide densely arranged tracks. A conventional technique is to form pits without consideration of the positional relation to two adjacent pits on an adjacent track, and thus it is necessary to keep a wider track interval. On the contrary, according to the present invention, a patterned member is configured such that each of the pits is positioned to keep the same distance from two adjacent pits on an adjacent track, it is possible to make the track interval narrower to arrange the pits densely on the patterned member. According to the present invention, the term "track" indicates a conceptual line along which the pits are arranged in line, and does not necessarily mean that grooves or the like are actually formed on the surface of the patterned member.

In the above patterned member, it is preferable that the plurality of tracks are arranged substantially along a plurality of concentric circles. With this configuration where the plurality of pits are arranged in line along a plurality of circular tracks, formation of asperities can be easily performed by exposing a substrate having a photoresist layer with light while rotating the substrate.

In the above patterned member, if an average distance between adjacent pits is in the range of 1-10000 nm, the patterned member can be used as an optical element for improving interface trasmissivity. Herein, the term "distance" between pits means a straight-line distance connecting the center of one pit and the center of another pit, that is, a pitch. To calculate the average distance between adjacent pits, an ideal solution is to calculate the average of the distances for all pairs of adjacent pits. However, since an extremely large number of pits exist, for example, a group of 100 pits may be sampled to calculate the average distance based on the distances between adjacent pits of these 100 pits.

In order to arrange the pits densely on the patterned member, it is preferable that if an average distance between one pit and other six pits which are closest to the one pit is P, a distance between the one pit and each of the other six pits adjacent to the one pit is in the range of 0.9P-1.2P.

In the above patterned member, the plurality of tracks may form a single spiral track along which the plurality of pits are arranged in line. As an alternative, the plurality of pits arranged along the plurality of tracks may be arranged in line on a plurality of circles having different diameters.

According to the present invention which solves the aforementioned problem, there is provided a method for manufacturing a patterned member on which a dotted pattern is formed, comprising the steps of: preparing a substrate including a photoresist layer which undergoes a change in shape when it is illuminated and hence heated with an electromagnetic beam; scanning the substrate with the electromagnetic beam along a plurality of scanning paths which are substantially parallel to one another, while changing an output of the electromagnetic beam at predetermined intervals, such that a plurality of dot-like pits are arranged in line along a plurality of tracks; and increasing the output of the electromagnetic beam to form a pit on one track that is next and adjacent to a track along which the plurality of pits have been formed, when the electromagnetic beam reaches a position corresponding to a midpoint between two adjacent pits arranged on the adjacent track as viewed in a direction along which the tracks extend.

With this manufacturing method, a plurality of pits arranged in line along a plurality of substantially parallel tracks can be arranged such that each pit is positioned at a position corresponding to a midpoint between two adjacent pits arranged on an adjacent track. Namely, the plurality of pits can be arranged densely on the substrate.

In the above manufacturing method, it is preferable that the scanning step may comprise, during an exposure of the photoresist layer with the electromagnetic beam, rotating the substrate and moving a light beam source for generating the electromagnetic beam in a direction toward and away from a center of rotation of the substrate, so that the scanning paths are defined by a plurality of substantially concentric circles.

Since exposure is carried out while rotating the substrate, an efficient exposure of the photoresist layer can be performed. It is noted that if a plurality of pits are formed consecutively along the scanning paths over the entire surface of the patterned member, the distance between adjacent pits does not become constant depending on a radial distance from the center of rotation of the substrate. Therefore, for implementation of this manufacturing method, instead of performing the scanning step to form a plurality of pits consecutively over the entire surface of the substrate, the surface of the substrate is divided into plural regions and the scanning step is performed consecutively in each divided region.

In the above manufacturing method, the output increasing step may comprise generating a synchronizing signal when the substrate is directed to a predetermined orientation, and a timing at which the electromagnetic beam is emitted on a track by changing the output of the electromagnetic beam based on the synchronizing signal may be shifted by a half period with respect to that on an adjacent track.

The above manufacturing method may further comprise, after formation of the plurality of pits on the photoresist layer, performing an etching using the photoresist layer as a mask. According to this manufacturing method, it is possible to form asperities on the surface of the substrate by the material of the substrate.

Further, the above manufacturing method may comprise the steps of: after formation of the plurality of pits on the photoresist layer, forming a film on the substrate at positions where the substrate is exposed to view through the plurality of pits; and removing the photoresist layer. According to this manufacturing method, it is possible to form asperities on the surface of the substrate by the film.

In the above manufacturing method, it is preferable that an average distance between adjacent pits is in the range of 1-10000 nm. It is also preferable that if an average distance between one pit and other six pits which are closest to the one pit is P, a distance between the one pit and each of the other six pits adjacent to the one pit is in the range of 0.9P-1.2P. Further, in the above manufacturing method, the scanning step may comprise scanning the substrate with the electromagnetic beam along a single spiral track formed by the plurality of tracks, so that the plurality of pits are arranged in line along the spiral track. As an alternative, the scanning step may comprise scanning the substrate with the electromagnetic beam along a plurality of circles having different diameters, so that the plurality of pits are arranged in line on the plurality of circles.

When asperities are formed on the surface of the substrate using a film, pits formed on the photoresist layer become projections in the end. In this case, the distance between adjacent pits can be seen as the distance between adjacent projections on the finished patterned member.

### ADVANTAGEOUS EFFECTS OF INVENTION

According to the patterned member and the method for manufacturing the patterned member of the present invention, a plurality of densely arranged pits can be formed on the surface in a simple manner.

### BRIEF DESCRIPTION OF DRAWINGS

FIG. 1 is a perspective view of a silicon substrate on which is formed a plurality of LED chips, each of which is an example of a patterned member according to the present invention.
FIG. 2 is a sectional view of the silicon substrate.
FIG. 3 is an enlarged view of the LED chip.
FIG. 4 is an enlarged view of pits formed on the surface of the LED chip.
FIG. 5 is a schematic diagram of a laser processing device used for forming pits.
FIG. 6 is a timing chart showing a synchronizing signal and exposure signals during laser processing.
FIG. 7 includes views explaining a manufacturing method for a patterned member according to a modified embodiment, in which (a) shows an etching process, and (b) shows a photoresist layer removal process.
FIG. 8 includes views explaining a manufacturing method for a patterned member according to another modified embodiment, in which (a) shows a plating process, and (b) shows a photoresist layer removal process.

### DESCRIPTION OF EMBODIMENTS

A patterned member and a manufacturing method for the patterned member according to the present invention will be described below in connection with one exemplary embodiment.

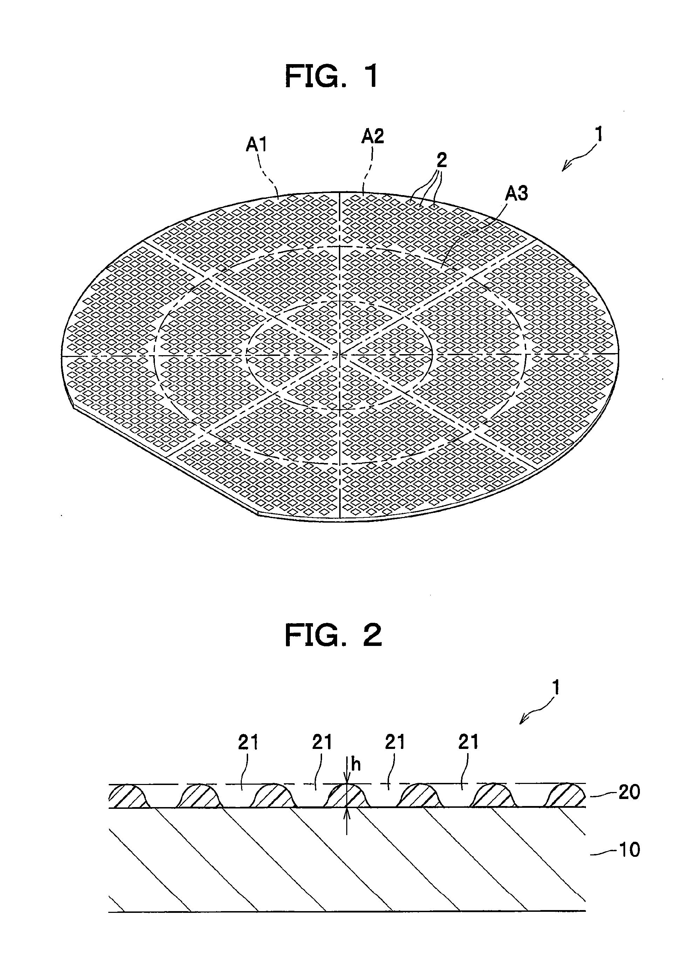

As seen in FIG. 1, a silicon substrate in the process of manufacturing a plurality of LED chips 2 (hereinafter referred to as a "workpiece" 1) is substantially shaped like a circular disc as a whole. LED chips 2 are formed by a manufacturing technique for semiconductor circuits and provided on the workpiece 1 within a plurality of regions A1, A2, A3 ... which are divided in peripheral and radial directions of the workpiece 1.

As best seen in FIG. 2, the workpiece 1 includes a substrate 10 made of silicon (illustration of the circuit is omitted), and a photoresist layer 20 provided on the substrate 10.

The photoresist layer 20 is made of a photoresist material which undergoes a change in shape due to deformation and vaporization of the material when it is illuminated and hence heated with an electromagnetic beam such as light and X-rays, that is, a thermally deformable heat mode photoresist material. The thickness of the photoresist layer 20 is appropriately set, for example, in the range of 1-10000 nm. The lower limit of the thickness is preferably 10 nm, and more preferably 50 nm. The upper limit of the thickness is preferably 1000 nm, and more preferably 500 nm.

To form the photoresist layer 20, a substance which can act as a photoresist material is dissolved or dispersed in an appropriate solvent to prepare a coating liquid. Thereafter, the coating liquid is coated on the surface of the substrate 10 by a coating method such as spin coating, dip coating, and extrusion coating, so that the photoresist layer 20 can be formed.

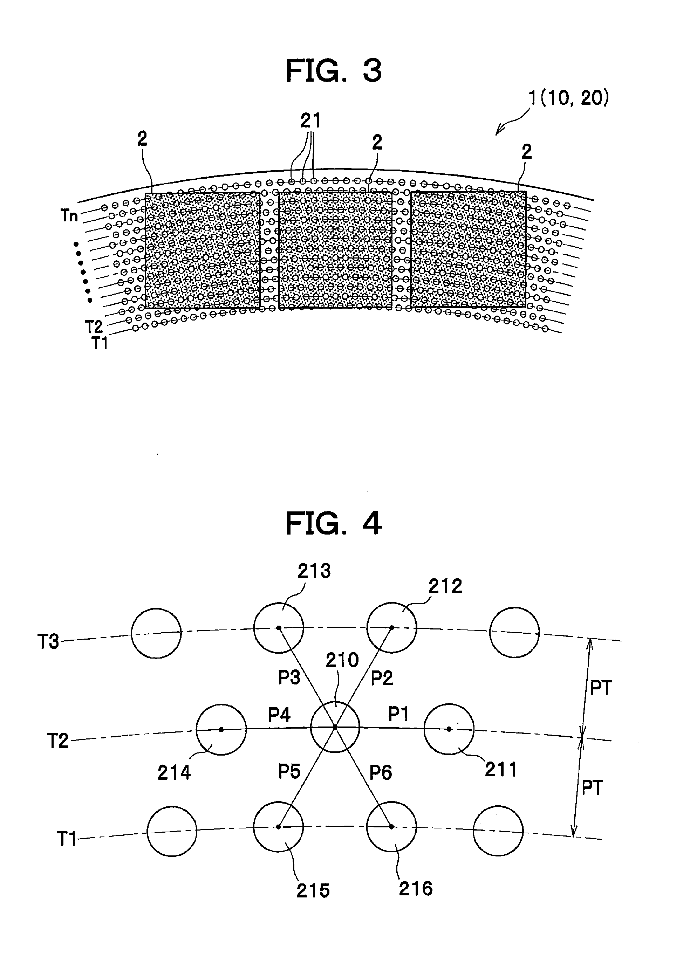

A plurality of pits 21 are formed on the photoresist layer 20. As best seen in FIG. 3, these pits 21 are arranged in line along tracks T1, T2, ...Tn, which are arranged substantially along a plurality of concentric circles. The tracks T1, T2, ... Tn may be a plurality of discrete circles having different diameters, or may form a single spiral track by connecting adjacent tracks. For the purpose of effectively forming the pits 21, it is preferable that the tracks T1, T2, ... Tn form a single spiral track to enable a consecutive exposure. In the following description, the photoresist layer 20 has tracks T1, T2, ... Tn that form a single spiral track.

As best seen in FIG. 4, each of the pits 21 is positioned, as viewed in a circumferential direction (*i.e*., in a direction along which the track Tn extends), at a position corresponding to a midpoint between two adjacent pits arranged on an adjacent track Tn. For example, with reference to FIG. 4, a center pit 210 is on the track T2, and as viewed in the circumferential direction, the center pit 210 is positioned at a position corresponding to a midpoint between two adjacent pits 215, 216 arranged on an inner adjacent track T1. Similarly, as viewed in the circumferential direction, the center pit 210 is positioned at a position corresponding to a midpoint between two adjacent pits 212, 213 arranged on an outer adjacent track T3.

The center pit 210 is positioned at the center of a hexagon defined by connecting the nearest six pits 211-216 surrounding the center pit 210, and the six pits 211-216 are substantially positioned at apices of a regular hexagon. Therefore, pitches P1-P6 from the center pit 210 to six adjacent pits 211-216 are substantially equal to each other. The track pitch PT is √3/2 times the pitch P1-P6 of each pit 21. Namely, pits 21 are arranged at the center and six apices of a regular hexagon as in the case of a close-packed hexagonal lattice. Hereinafter, such an arrangement of the pits 21 according to this embodiment is referred to as a "hexagonal lattice" as a matter of convenience. By this arrangement, the pits 21 can be densely arranged with a distance between adjacent pits. Although it is impossible as a matter of manufacture that all the pits 21 are arranged at the same pitch, it is preferable that if an average distance between one pit and other six pits which are closest to the one pit is P, a distance between each pit 21 (*e.g*., pit 210) and each of the other six pits (*e.g*., pits 211-216) adjacent to this pit 21 (*e.g*., pit 210) is in the range of 0.9P-1.2P.

In the case of the workpiece 1 on which a plurality of pits 21 are arranged in line along tracks T1, T2, ... Tn that form a single spiral track, the pits 21 will not be positioned on hexagonal lattice points because the pitch between two adjacent pits 21 changes gradually depending on a distance from the center (*i.e*., radius). For this reason, according to this embodiment, the surface of the workpiece 1 is radially divided into a plurality of areas, and pits 21 are arranged in each of the areas so as to form consecutive hexagonal lattices. In accordance with the areas in which the pits 21 are consecutively arranged to form consecutive hexagonal lattices, LED chips 2 are formed in a consecutive manner within the areas, and these radially divided areas are illustrated in FIG. 1 as regions A1, A2, A3, etc. It is to be noted that although a plurality of divided regions are also formed in the circumferential direction as shown in FIG. 1, it is not necessary to divide the surface of the workpiece 1 in the circumferential direction.

More specifically, it is preferable that the size of the pitch P is in the range of 1-10000 nm. Setting the pitch size equal to or smaller than 10000 nm as described above allows the patterned member to be used as an optical element with improved light transmittance at an interface. Setting the pitch size equal to or greater than 1 nm makes it possible to prevent adjacent pits from being connected to each other. In terms of formation of discrete pits, it is more preferable that the size of the pitch P is equal to or greater than 10 nm. Further preferably, the size of the pitch P is equal to or greater than 50 nm, and most preferably equal to or greater than 100 nm. Further, in terms of improvement in the light transmittance at the interface, it is more preferable that the size of the pitch P is equal to or less than 5 µm. Further preferably, the size of the pitch P is equal to or less than 2 µm, and most preferably equal to or less than 1 µm.

The ratio of the height between pits (*i.e*., height of a land) to the film thickness is preferably equal to or greater than 40%, and more preferably, equal to or greater than 60%.

As described above, since the workpiece 1 according to this embodiment is provided with an arrangement of fine pits 21 (*i.e*., asperities) on the surface of the photoresist layer 20, light emitted from the LED chip 2 can be successfully and excellently taken out outside the LED chip 2. Further, since the fine asperities are formed, as shown in FIG. 4, such that a plurality of pits are arranged on lattice points of the hexagonal lattice, the distance between adjacent pits can be kept constant and the pitch can be set to a smaller value. Since the conventional technique does not consider the positional relation of pits in the circumferential direction, one pit may be positioned at a position corresponding to a midpoint between two adjacent pits arranged on an adjacent track while another pit may be positioned at the same circumferential position (*i*.*e*., on the same diameter) with respect to an adjacent pit on an adjacent track. If the pitch between two adjacent pits is not constant, it is necessary to set a wider track interval for the purpose of leaving a sufficient land height h between pits *(see* FIG. 2). This is because a large track pitch is required for ensuring a sufficient land height h between adjacent pits in case that a pit on one track and another closest pit on an adjacent track are arranged in line on the same diameter.

According to this embodiment, since the pitch between adjacent pits on two adjacent tracks is constant, a plurality of pits can be densely arranged and a uniform and sufficient land height h can also be ensured throughout the densely arranged pits, with the result that asperities can be formed in a precipitous manner. Therefore, an excellent light transmittance can be realized in view of manufacturing an optical element with improved light transmittance at the interface.

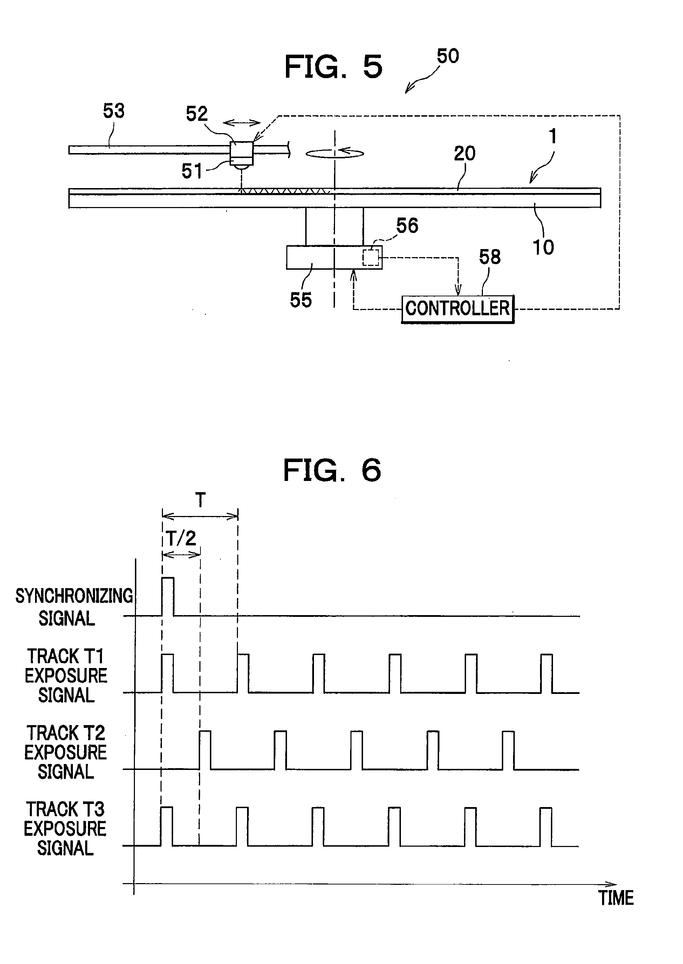

Next, with reference to FIGS. 5 and 6, a method for manufacturing a silicon substrate, on which is formed a plurality of LED chips, each of which is an example of a patterned member according to the present invention, will be described.

FIG. 6 indicates a time relationship between exposure signal for each track and synchronizing signal, but does not indicate that a plurality of tracks are simultaneously exposed with light.

In principle, a laser processing device 50 shown in FIG. 5 is similar to a laser exposure device such as a CD-R drive, but is adapted for exposing a photoresist layer 20 according to this embodiment with light and configured to control the rotation speed of a workpiece 1 and the output of a laser beam source 51 by a controller 58.

The laser processing device 50 includes a laser beam source 51, a liner actuator 52, a guide rail 53, a rotary stage 55, an encoder 56, and a controller 58.

The laser beam source 51 is an example of a light beam source for generating an electromagnetic beam. In order to form a pit 21 on the photoresist layer 20, the photoresist layer 20 may be illuminated with an electromagnetic beam having a wavelength within a light absorption wavelength region of a material constituting the photoresist layer 20, and a laser beam source 51 for generating such an electromagnetic beam may be selected in this regard. Of course, the material constituting the photoresist layer 20 may be selected based on the wavelength of the laser beam emitted from the laser beam source 51. A laser beam having a shorter wavelength is preferable in terms of formation of fine pits. For this reason, the wavelength of the laser beam is preferably equal to or less than 800 nm, more preferably equal to or less than 700 nm, and further more preferably equal to or less than 600 nm. On the contrary, in terms of successful and excellent laser processing while suppressing absorption and scattering of light by air, a laser beam having a longer wavelength is preferable. For this reason, the wavelength of the laser beam is preferably equal to or longer than 10 nm, more preferably equal to longer than 100 nm, and further more preferably equal to or longer than 150 nm. For example, the laser beam having a wavelength around 405 nm may be preferably used.

The linear actuator 52 is a known device for linearly moving the laser beam source 51 in a radial direction of the workpiece 1. The guide rail 53 extends along the radial direction of the workpiece 1, and the linear actuator 52 causes the laser beam source 51 to move along the guide rail 53.

The rotary stage 55 is a known device for supporting the workpiece 1 while being rotated. The workpiece 1 is attached to the rotary stage 55 with the center of the circular disc-shaped workpiece 1 coincident with the center of rotation of the rotary stage 55.

The encoder 56 is provided on the rotary stage 55 and generates a synchronizing signal each time when the rotary stage 55 rotates for a predetermined angle. For example, the encoder 56 outputs a synchronizing signal each time when the rotary stage 55 makes one rotation. The output from the encoder 56 is input to the controller 58.

The controller 58 is a device for controlling the laser beam source 51, the linear actuator 52, and the rotary stage 55. The controller 58 controls the rotation speed of the rotary stage 55 based on the output from the encoder 56, and causes the laser beam source 51 1 to blink at appropriate timings. Further, for the purpose of exposing the entire surface of the workpiece 1 with the laser beam as well as for keeping an appropriate pitch PT between tracks, the controller 58 is configured to control the linear actuator 52 to move the laser beam source 51 in the radial direction (*i.e*., in a direction toward and away from the center of rotation of the substrate) at an appropriate speed.

Although detailed description will be omitted, the laser beam emitted from the laser beam source 51 is focused on the photoresist layer 20. To perform a focus servo during the exposure, the laser beam is illuminated at a lower output even at a part of the photoresist layer where a change of shape should not be effected. It is therefore to be noted that blinking of the laser beam indicates that the output of the laser beam is increased or decreased, and does not necessarily means that the laser beam is turned off for blinking.

As best seen in FIG. 6, the timing at which the controller 58 causes the laser beam source 51 to emit the laser beam (*i.e*., strictly speaking, in this embodiment, the output of the laser beam is changed from a low-output state to a high-output state where a change of shape can be effected on the photoresist layer 20; hereinafter this action is simply referred to as "emission") is determined based on the synchronizing signal input from the encoder 56. The encoder 56 generates the synchronizing signal when the rotary stage 55 (i. e., the substrate 10) is directed to a predetermined orientation. The controller 58 then controls the emission timing for each track based on the synchronizing signal. To be more specific, the controller 58 causes the laser beam source 51 to emit the laser beam such that emissions of the laser beam on one track are shifted by a half-period from those on another track adjacent thereto. For example, as shown in FIG. 6, if emissions are taken place on the track T1 with a timing conformable to the pulsation of the synchronizing signal, on the next track T2 adjacent to the track T1, emissions are taken place with a timing delayed from the pulsation of the synchronizing signal by a half-period (T/2). Further, on the next track T3 adjacent to the track T2, emissions are shifted by a half-period from those on the track T2 and with a timing conformable to the pulsation of the synchronizing signal. By this control, as viewed in the circumferential direction of the workpiece 1, each pit 21 on one track is positioned at a position corresponding to a midpoint between two adjacent pits arranged on an adjacent track.

The interval or period of time T may be reset where appropriate in accordance with the regions divided in the radial direction. For example, if the workpiece 1 is rotated at a constant angular velocity, the period of time T is set smaller for processing at the outer region A2 than at the inner region A3.

Description will be given of the method for manufacturing a workpiece 1 (patterned member) of FIG. 1 using the laser processing device 50 as described above.

First, a substrate 10 on which a plurality of LED chips 2 are formed is prepared. A photoresist material is dissolved in an appropriate solvent to prepare a coating liquid, which is then coated on the surface of the substrate 10 by spin coating or the like. Accordingly, the photoresist layer 20 is formed on the substrate 10. The substrate 10 coated with the photoresist layer 20 is then supported on the rotary stage 55. At this time, the center of the substrate 10 is positioned to coincide with the center of rotation of the rotary stage 55.

Next, the controller 58 causes the rotary stage 55 to rotate at a predetermined rotation speed. The controller 58 causes the laser beam source 51 to initiate blinking of the laser beam for exposure after the rotation speed of the rotary stage 55 becomes stable. As described above, the exposure timing is determined based on the synchronizing signal input from the encoder 56. This allows the laser beam source 51 to emit the laser beam at a timing shifted by a half period as compared with the adjacent inner track on which the pits 21 have been formed.

By this exposure process, the photoresist material vaporizes from the photoresist layer 20 only at positions where the laser beam emitted at a higher laser-output strikes, and pits 21 are formed on the photoresist layer 20. Since the emission timing is shifted by a half period between two adjacent tracks, as best seen in FIG. 4, each pit 21 can be formed, as viewed in the circumferential direction of the workpiece 1, at a position corresponding to a midpoint between two adjacent pits arranged on an adjacent track.

As described above, since each of the pits 21 is arranged, as viewed in the circumferential direction (scanning direction) of the workpiece 1, at a position corresponding to a midpoint between two adjacent pits arranged on an adjacent track, the workpiece 1 can be configured such that each of the pits 21 is positioned to keep the same distance between adjacent pits on two adjacent tracks and thus to provide densely arranged pits 21. Especially, in the case of the arrangement as shown in FIG. 4 where the pits 21 are arranged on lattice points of a hexagonal lattice, the pits 21 can be formed densely while ensuring a sufficient land height h between pits, with the result that asperities can be formed in a precipitous manner. Therefore, an asperity pattern comprising precipitous-shaped pits can be formed on the surface of the LED chip 2, which leads to improved light transmittance at the interface of the substrate 10.

Although the present invention has been described above with reference to one exemplary embodiment of the present invention, the present invention is not limited to the above specific embodiment and various changes and modification may be made where appropriate. For example, according to the above embodiment, asperities are formed on the photoresist layer 20 provided on the substrate 10, so that the workpiece 1 has improved light transmittance at the interface. However, the photoresist layer 20 may be used as a mask, and asperities may be formed by a thin-film formation process such as etching or plating so that the asperities on the substrate 10 per se or the asperities made by the film can improve the light transmittance at the interface.

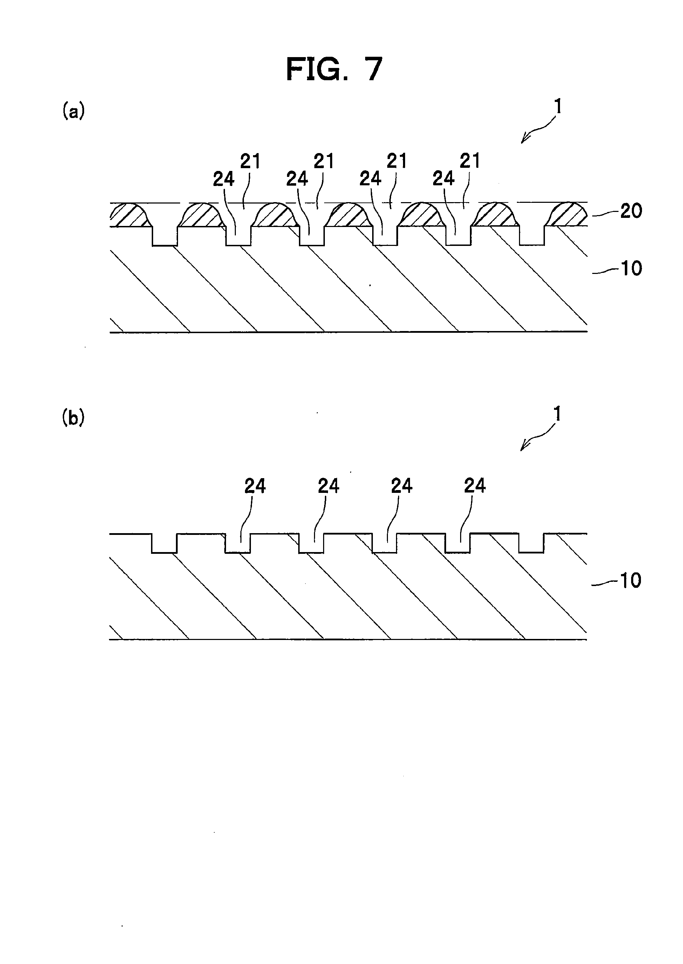

For example, as best seen in FIG. 7 (a), the substrate 10 may be etched using the photoresist layer 20, on which a plurality of pits 21 are formed, as a mask, and a plurality of pits 24 are formed on the surface of the substrate 10. Thereafter, as seen in FIG. 7 (b), the photoresist layer 20 is removed by a solvent or the like, so that a plurality of pits 24 can be directly formed on the surface of the substrate 10.

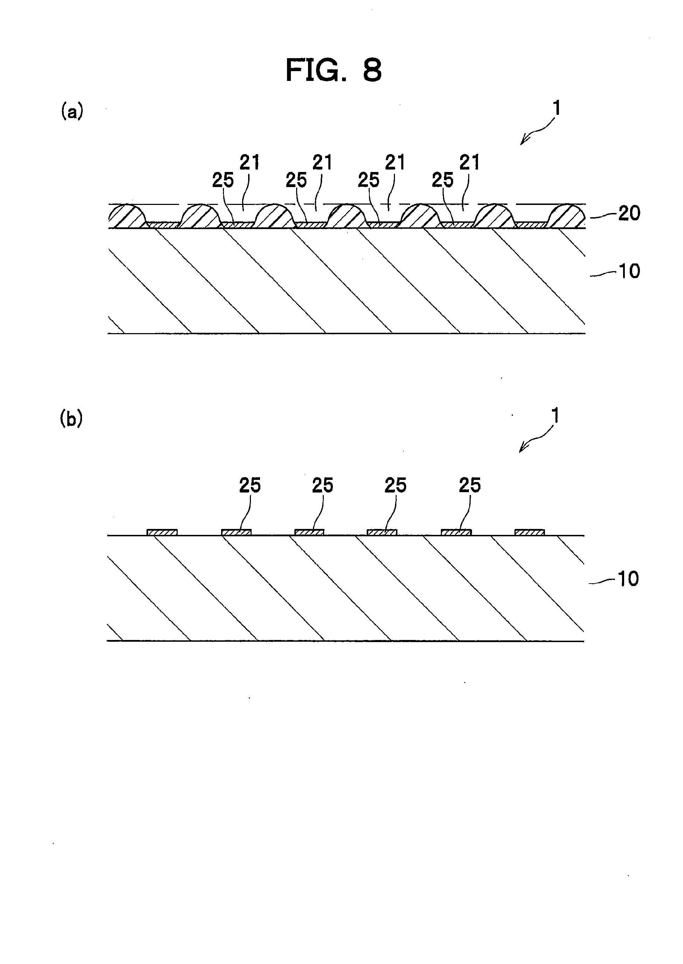

Further, the surface of the substrate 10 may be provided with conductivity (not shown) in advance, and as seen in FIG. 8 (a), plating is applied to conductive layer portions exposed to view through the pits 21. Thereafter, as seen in FIG. 8 (b), the photoresist layer 20 is removed by a solvent, so that asperities can be provided on the surface of the substrate 10 by plating.

As described above, an asperity pattern may be formed on the patterned member using a material other than the photoresist material.

Further, in the above exemplary embodiment, a plurality of pits 21 are formed on substantially concentric circular tracks by exposing the photoresist layer 20 with the laser beam while rotating the workpiece 1. However, the pits 21 may be arranged in orthogonally crossing x-y directions. In this example, the photoresist layer may be scanned with the laser beam in the x-y directions using a two-axis galvanometer mirror.

In the above exemplary embodiment, the encoder 56 is provided on the rotary stage 55 to detect the orientation of the substrate 10. However, a reference mark may be formed on the substrate 10, and the reference mark may be optically detected to detect the orientation of the substrate 10.

In the above exemplary embodiment, pits 21 are supposed to be formed on all the lattice points of the hexagonal lattice. However, in accordance with the intended use of the patterned member, some of the pits 21 may be partly omitted.

Specific examples of the heat mode type photoresist material as disclosed in the above embodiment, and the conditions for processing the photoresist layer are as follows.

The heat mode type photoresist material which may be adopted includes recording materials as hitherto used generally in the recording layer of optical discs or the like; for example, recording materials such as cyanine-based, phthalocyanine-based, quinone-based, squarylium-based, azulenium-based, thiol complex salt-based, and merocyanine-based recording materials may be used for our purpose.

The photoresist layer according to the present invention may preferably be of a dye type, which contains a dye as a photoresist material.

Therefore, the photoresist material contained in the photoresist layer may be selected from dyes or other organic compounds. It is to be understood that the photoresist material is not limited to organic material; that is, an inorganic material or a composite material of organic and inorganic materials may also be employed. With the organic materials, however, the coating process for forming a film can be performed easily by spin coating or spraying, and a material having a lower transition temperature is readily available; thus, the organic materials may be preferable. Further, amongst various organic materials, dyes whose light absorption can be controlled by varying their molecular design may be preferable.

Preferred examples of material for use in the photoresist layer may include methine dyes (cyanine dyes, hemicyanine dyes, styryl dyes, oxonol dyes, merocyanine dyes, etc.), large ring dyes (phthalocyanine dyes, naphthalocyanine dyes, porphyrin dyes, etc.), azo dyes (including an azo-metal chelate dye), arylidene dyes, complex dyes, coumarin dyes, azole derivatives, triazine derivatives, 1-aminobutadiene derivatives, cinnamic acid derivatives, quinophthalone dyes, etc. Of these, methine dyes, oxonol dyes, large ring dyes, and azo dyes may be preferable.

This dye-type photoresist layer may preferably contain a dye having absorption in the range of exposure light wavelengths. Particularly, the upper limit value of an extinction coefficient k indicating the amount of light absorption may preferably be 10, more preferably 5, still more preferably 3, and most preferably 1. On the other hand, the lower limit value of the extinction coefficient k may preferably be 0.0001, more preferably 0.001, and still more preferably 0.1. Setting the extinction coefficient k within the above range preferably makes the shapes of the pits uniform.

It is to be understood, as described above, that the photoresist layer needs to have absorption of light in the range of exposure light wavelengths; with this in view, the selection of an appropriate dye and/or alteration of its structure may be made in accordance with the wavelength of the laser beam produced by the laser light source.

For example, in the case where the oscillation wavelength of the laser beam emitted from the laser light source is around 780 nm (near-infrared region), it is advantageous to select dyes such as pentamechine cyanine dyes, heptamechine oxonol dyes, pentamethine oxonol dyes, phthalocyanine dyes, and naphthalocyanine dyes. Of these, phthalocyanine dyes or pentamethine cyanine dyes may be used preferably in particular.

In the case where the oscillation wavelength of the laser beam emitted from the laser light source is around 660 nm (visible region), it is advantageous to select dyes such as trimechine cyanine dyes, pentamethine oxonol dyes, azo dyes, azo-metal complex dyes, and pyrromethene complex dyes.

Further, in the case where the oscillation wavelength of the laser beam emitted from the laser light source is around 405 nm (near-ultraviolet region), it is advantageous to select dyes such as monomechine cyanine dyes, monomechine oxonol dyes, zero-mechine merocyanine dyes, phthalocyanine dyes, azo dyes, azo-metal complex dyes, porphyrin dyes, arylidene dyes, complex dyes, coumarin dyes, azole derivatives, triazine derivatives, benzotriazole derivatives, 1-aminobutadiene derivatives, and quinophthalone dyes.

Examples of preferred compounds for use in the photoresist layer (*i.e.,* as a photoresist material) are shown below in the cases where the oscillation wavelength of the laser beam emitted from the laser light source is around 780 nm, around 660 nm, and around 405 nm, respectively. Compounds given by (I-1) to (I-10) in the following chemical formulae 1, 2 are suitable in the case where the oscillation wavelength of the laser beam is around 780 nm. Compounds given by formulae (II-1) to (II-8) in the chemical formulae 3, 4 are suitable in the case where the oscillation wavelength of the laser beam is around 660 nm, and compounds given by (III-1) to (III-14) in the chemical formulae 5, 6 are suitable in the case where the oscillation wavelength of the laser beam is around 405 nm. It is to be understood that the present invention is not limited to the case where these compounds are used as the photoresist material.

### Examples of photoresist material in the case of laser oscillation wavelength around 780 nm (near-infrared region),

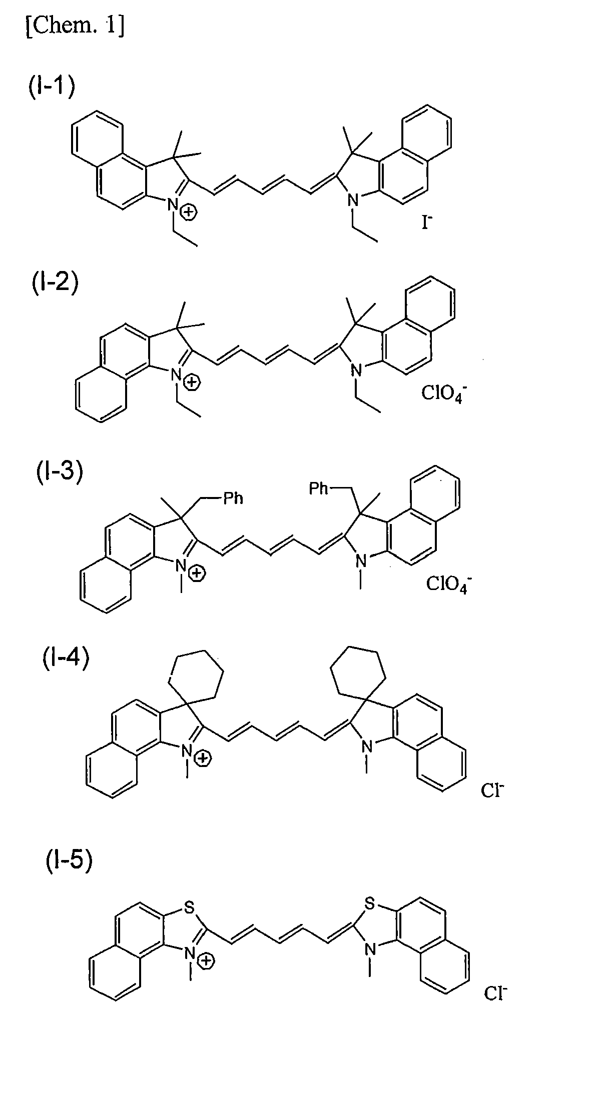

### Examples of photoresist material in the case of laser oscillation wavelength around 780 nm (near-infrared region),

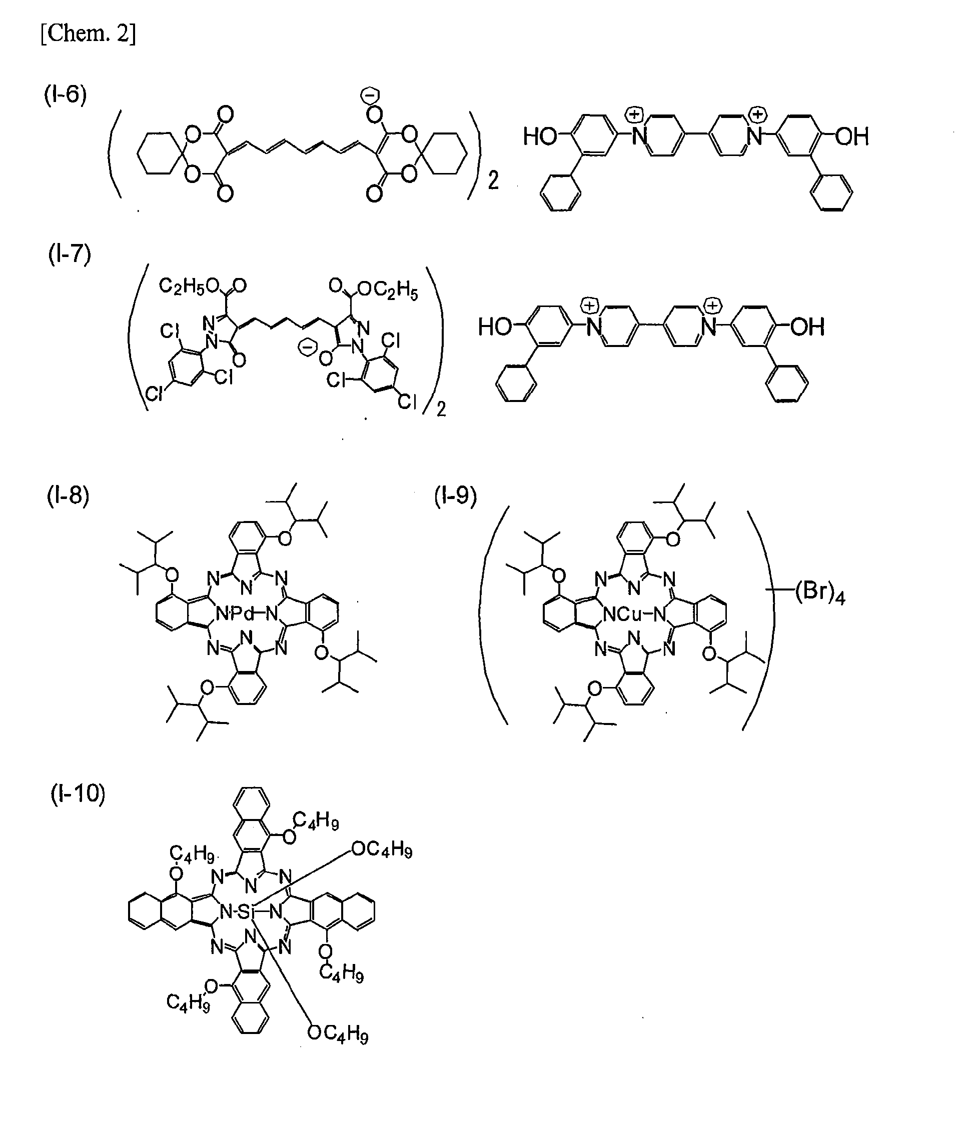

### Examples of photoresist material in the case of laser oscillation wavelength around 660 nm (visible region)

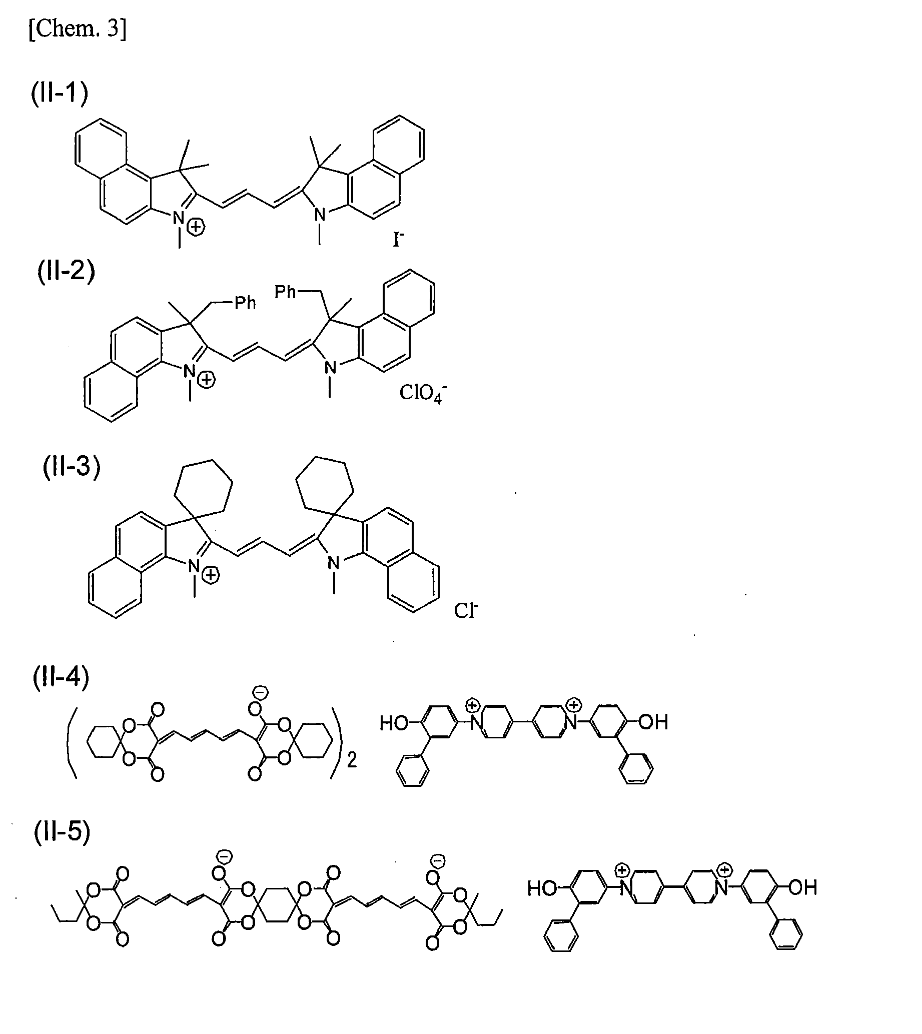

### Examples of photoresist material in the case of laser oscillation wavelength around 660 nm (visible region)

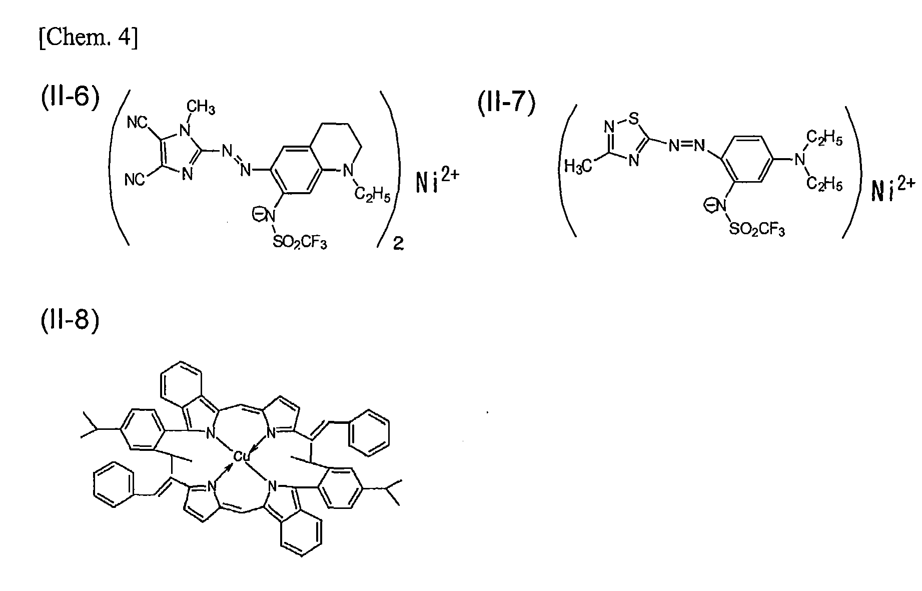

### Examples of photoresist material in the case of laser oscillation wavelength around 405 nm (near-ultraviolet region)

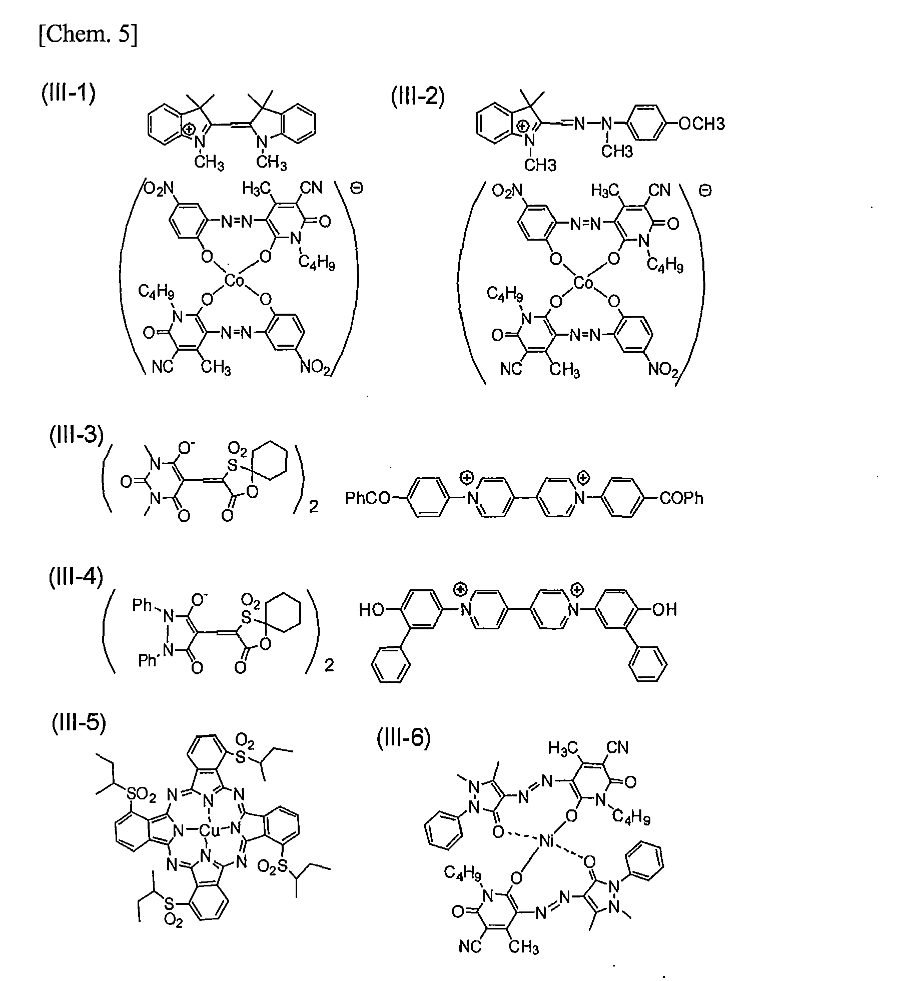

### Examples of photoresist material in the case of laser oscillation wavelength around 405 nm (near-ultraviolet region)

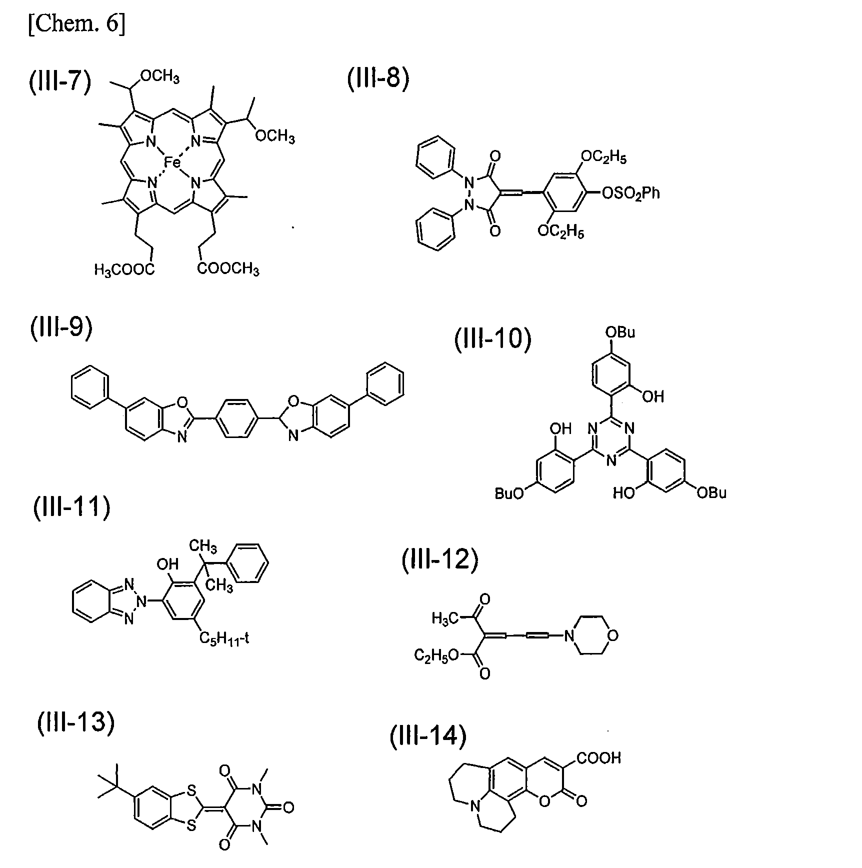

Dyes described in Japanese Laid-open Patent Applications, Publication (JP-A) Nos. 4-74690, 8-127174, 11-53758, 11-334204, 11-334205, 11-334206, 11-334207, 2000-43423, 2000-108513, and 2000-158818 can also preferably be used.

The dye-type photoresist layer may be formed by dissolving a dye in an adequate solvent along with a binding agent, etc. to prepare a coating liquid, then applying the coating liquid on a substrate to form a coating film, and thereafter drying the resulting coating film. In this process, the temperature of a surface on which the coating liquid is applied may preferably be in the range of 10-40 degrees centigrade. More preferably, the lower limit value thereof may be 15 degrees centigrade, still more preferably 20 degrees centigrade, and particularly preferably 23 degrees centigrade. Meanwhile, the upper limit value thereof may be more preferably 35 degrees centigrade, still more preferably 30 degrees centigrade, and particularly preferably 27 degrees centigrade. When the temperature of the coated surface is in the above ranges, uneven application of the coating and coating failure can be prevented, so that a thickness of the coating film can be made uniform.

Each of the upper and lower limits mentioned above may be arbitrarily combined with each other.

Here, the photoresist layer may be either mono-layered or multi-layered. In the case of the photoresist layer having a multi-layered configuration, the coating step is repeated plural times.

A concentration of the dye in the coating liquid is generally in the range of 0.01-15 mass percent, preferably in the range of 0.1-10 mass percent, more preferably in the range of 0.5-5 mass percent, and most preferably in the range of 0.5-3 mass percent.

Examples of the solvent for the coating liquid include: esters such as butyl acetate, ethyl lactate and cellosolve acetate; ketones such as methyl ethyl ketone, cyclohexanone, and methyl isobutyl ketone; chlorinated hydrocarbons such as dichloromethane, 1,2-dichloroethane and chloroform; amides such as dimethylformamide; hydrocarbons such as methylcyclohexane; ethers such as tetrahydrofuran, ethyl ether, and dioxane; alcohols such as ethanol, n-propanol, isopropanol, n-butanol, and diacetone alcohol; fluorinated solvents such as 2,2,3,3-tetrafluoropropanol; and glycol ethers such as ethylene glycol monomethyl ether, ethylene glycol monoethyl ether and propylene glycol monomethyl ether. Fluorinated solvents, glycol ethers and ketones are preferable. Particularly preferable are fluorinated solvents and glycol ethers. Further preferable are 2,2,3,3-tetrafluoropropanol and propylene glycol monomethyl ether.

Taking the solubility of the dye used in the solvents into consideration, the above solvents may be used singly or in a combination of two or more kinds thereof. Various kinds of additives such as an antioxidant, a UV absorbent, a plasticizer and a lubricant may be added in the coating liquid depending on the purpose.

Coating methods such as spray method, spin coating method, dip method, roll coat method, blade coat method, doctor roll method, doctor blade method, and screen printing method are applicable. Of these methods, the spin coating method is preferable in terms of its excellent productivity and easy controllability of the film thickness.

In order to form the photoresist layer better by the spin coating method, the dye may be dissolved in the organic solvent preferably in the range of 0.3-30 wt%, more preferably in the range of 1-20 wt%. In particular, it is preferable that the dye is dissolved in tetrafluoropropanol in the range of 1-20 wt%. It is also preferable that the thermal decomposition temperature of the photoresist material be in the range of 150-500 degrees centigrade, and more preferably in the range of 200-400 degrees centigrade.

The temperature of the coating liquid at the time of coating may preferably be in the range of 23-50 degrees centigrade, more preferably in the range of 24-40 degrees centigrade, and particularly preferably in the range of 25-30 degrees centigrade.

In the case where the coating liquid contains a binding agent, examples of the binding agent include natural organic polymers such as gelatin, cellulose derivatives, dextran, rosin and rubber; and synthetic organic polymers including hydrocarbonic resins such as polyethylene, polypropylene, polystylene and polyisobutylene, vinyl resins such as polyvinylchloride, polyvinylidene chloride and polyvinylchloride-polyvinyl acetate copolymers, acrylic resins such as polymethyl acrylate and polymethyl methacrylate, and initial condensates of thermosetting resins such as polyvinyl alcohol, chlorinated polyethylene, epoxy resin, butyral resin, rubber derivatives and phenol formaldehyde resin. In the case where the binding agent is used together as a material for the photoresist layer, the amount of the binding agent used is generally in the range of 0.01-50 times the amount of dye (mass ratio), and preferably in the range of 0.1-5 times the amount of dye (mass ratio).

In order to increase the lightfastness of the photoresist layer, various antifading agents may be contained in the photoresist layer.

In general, a singlet oxygen quencher is used for the antifading agent. As examples of such singlet oxygen quencher, those described in published documents such as patent specifications hitherto known in the art can be used.

Specific examples of such patent specifications include: Japanese Laid-open Patent Applications, Publication (JP-A) Nos. 58-175693, 59-81194, 60-18387, 60-19586, 60-19587, 60-35054, 60-36190, 60-36191, 60-44554, 60-44555, 60-44389, 60-44390, 60-54892, 60-47069, 63-209995, and 4-25492; Japanese Examined Patent Applications, Publication (JP-B) Nos. 1-38680 and 6-26028; German Patent No. 350399; and Nippon Kagaku Kaishi, October (1992), p. 1141. The use amount of the antifading agent such as a singlet oxygen quencher relative to the amount of dye is generally in the range of 0.1-50 mass percent, preferably in the range of 0.5-45 mass percent, more preferably in the range of 3-40 mass percent, and particularly preferably in the range of 5-25 mass percent.

The photoresist layer may also be formed by any film-forming method such as evaporation, sputtering and CVD, which may be selected depending on the physical properties of the material to be used therein.

The dye to be used is such that a light absorptance thereof at the wavelength of a laser beam used in the processing of a pattern of pits is higher than those at the other wavelengths.

The wavelength at which the dye exhibits the peak absorption may not necessarily fall within the range of the wavelengths of visible light, but may be within the range of the wavelengths of the ultraviolet or infrared region.

The wavelength λw of the laser beam to be emitted to form a pattern of pits may be any wavelength as long as a sufficiently high laser power is obtained. For example, in the case where a dye is used for the photoresist layer, the wavelength may preferably be 1,000 nm or less, such as 193 nm, 210 nm, 266 nm, 365 nm, 405 nm, 488 nm, 532 nm, 633 nm, 650 nm, 680 nm, 780 nm, and 830 nm.

The laser beam may be a continuous light beam or pulsed light beam. However, it is preferable to use a laser beam whose emission intervals can be changed freely. For example, the use of a semiconductor laser is preferable. In the case where the laser beam is not directly on-off keyed, it is preferable that the laser beam is modulated using an external modulation element.

In order to increase the processing speed, a higher laser power is preferable. However, the higher the laser power, the higher scanning speed (speed for scanning the photoresist layer with the laser beam; for example, rotation speed of the rotary stage 55 in the above-described embodiment) is required. For this reason, taking the upper limit value of the scanning speed into consideration, the upper limit value of the laser power is preferably 100 W, more preferably 10 W, and still more preferably 5 W, and most preferably 1 W. Meanwhile, the lower limit value of the laser power is preferably 0.1 mW, more preferably 0.5 mW, and still more preferably 1 mW.

It is preferable that the laser beam has a narrow range of oscillation wavelength and excels in coherency, and that the laser beam can be condensed to a spot size which is as small as the wavelength of the laser beam.

Further, it is preferable that the thickness t of the photoresist layer and the diameter d of the pit has the following relationship. Namely, the upper limit value of the thickness t of the photoresist layer preferably takes a value to satisfy the relationship as given by t<10d, more preferably takes a value to satisfy t<5d, and still more preferably to satisfy t<3d. The lower limit value of the thickness t of the photoresist layer preferably takes a value to satisfy the relationship as given by t>d/100, more preferably takes a value to satisfy t>d/10, and still more preferably to satisfy t>d/5. If the upper limit and lower limit values of the thickness t of the photoresist layer relative to the diameter d of the pit have the aforementioned relationships, the advantages similar to those described above such as the desired effect as etching mask and increased processing speed can be achieved.

### EXAMPLES

Next, one example implemented to verify the advantageous effects of the present invention will now be described.

### [EXAMPLE 1]

The photoresist material given by the following formula was dissolved in a TFP (tetrafluoropropanol) solvent at a concentration of 15 mg/ml to prepare an application liquid, and the resulting application liquid was applied on a glass substrate having a diameter of 4 inches (approximately 10 cm) by spin coating. The photoresist layer having a thickness of 70 nm was formed.

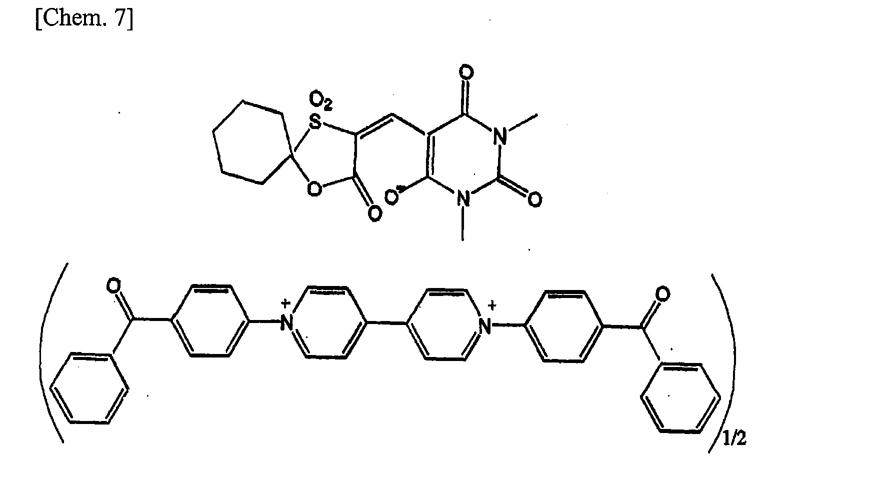

The photoresist layer was exposed with a laser beam in accordance with a manufacturing method similar to that described in the above embodiment, so that pits were formed on the photoresist layer.

Conditions for forming pits were as follows.

| | |
|---|---|
| Exposure device | NEO1000 manufactured by Pulstec Industrial Co., Ltd. |
| Track pitch | 200 nm |
| Laser output | 8 mW |
| Duty cycle of Exposure signal | 37% |
| Liner velocity | 5 m/s |
| Distances to six nearest pits | 1P (P=200 nm) for all distances (hexagonal lattice) |

Herein, the duty cycle is determined such that 100% corresponds to the scanning time of a pitch of adjacent pits in the scanning direction.

Pits were formed by the above process, and a uniform arrangement of pits was formed, in which each pit has a diameter of 100 nm and the land height between pits was 50 nm. A ratio of the land height to the film thickness of the photoresist layer was 71%.

### [EXAMPLE 2]

Pits were formed under the same conditions as those of the pit formation conditions described in EXAMPLE 1; however, each pit was arranged to form an orthorhombic lattice and distances from each pit to six nearest pits were in the range of 0.9-1.2P (P=200 nm). As a result, the land height between pits was 30 nm (a ratio of the land height to the film thickness of the photoresist layer was 43%).

### [COMPARATIVE EXAMPLE]

Pits were formed under the same conditions as those of the pit formation conditions described in EXAMPLE 1; however, each pit was arranged to form a tetragonal lattice and distances from each pit to six nearest pits were in the range of 0.88-1.24P (P=200 nm). As a result, the land height between pits was 10 nm (a ratio of the land height to the film thickness of the photoresist layer was 14%).

## Claims

1. A patterned member having a surface on which a dotted pattern is formed, comprising:
a substrate;
a photoresist layer which is provided on the substrate and undergoes a change in shape when it is illuminated and hence heated with an electromagnetic beam; and
a plurality of pits formed on the photoresist layer,
wherein the plurality of pits are arranged in line along a plurality of tracks which are substantially parallel to one another, and as viewed in a direction along which the tracks extend, each pit on one track is positioned at a position corresponding to a midpoint between two adjacent pits arranged on an adjacent track.

2. The patterned member according to claim 1, wherein the plurality of tracks are arranged substantially along a plurality of concentric circles.

3. The patterned member according to claim 1, wherein an average distance between adjacent pits is in the range of 1-10000 nm.

4. The patterned member according to any one of claims 1 to 3, wherein if an average distance between one pit and other six pits which are closest to the one pit is P, a distance between the one pit and each of the other six pits adjacent to the one pit is in the range of 0.9P-1.2P.

5. The patterned member according to claim 2, wherein the plurality of tracks form a single spiral track, and the plurality of pits are arranged in line along the spiral track.

6. The patterned member according to claim 2, wherein the plurality of pits arranged along the plurality of tracks are arranged in line on a plurality of circles having different diameters.

7. A method for manufacturing a patterned member on which a dotted pattern is formed, comprising the steps of:
preparing a substrate including a photoresist layer which undergoes a change in shape when it is illuminated and hence heated with an electromagnetic beam;
scanning the substrate with the electromagnetic beam along a plurality of scanning paths which are substantially parallel to one another, while changing an output of the electromagnetic beam at predetermined intervals, such that a plurality of dot-like pits are arranged in line along a plurality of tracks; and
increasing the output of the electromagnetic beam to form a pit on one track that is next and adjacent to a track along which the plurality of pits have been formed, when the electromagnetic beam reaches a position corresponding to a midpoint between two adjacent pits arranged on the adjacent track as viewed in a direction along which the tracks extend.

8. The method for manufacturing a patterned member according to claim 7, wherein the scanning step comprises, during an exposure of the photoresist layer with the electromagnetic beam, rotating the substrate and moving a light beam source for generating the electromagnetic beam in a direction toward and away from a center of rotation of the substrate, so that the scanning paths are defined by a plurality of substantially concentric circles.

9. The method for manufacturing a patterned member according to claim 8, wherein the output increasing step comprising generating a synchronizing signal when the substrate is directed to a predetermined orientation, and wherein a timing at which the electromagnetic beam is emitted on a track by changing the output of the electromagnetic beam based on the synchronizing signal is shifted by a half period with respect to that on an adjacent track.

10. The method for manufacturing a patterned member according to any one of claims 7 to 9, further comprising, after formation of the plurality of pits on the photoresist layer, performing an etching using the photoresist layer as a mask.

11. The method for manufacturing a patterned member according to any one of claims 7 to 9, further comprising the steps of:
after formation of the plurality of pits on the photoresist layer, forming a film on the substrate at positions where the substrate is exposed to view through the plurality of pits; and
removing the photoresist layer.

12. The method for manufacturing a patterned member according to claim 7, wherein an average distance between adjacent pits is in the range of 1-10000 nm.

13. The method for manufacturing a patterned member according to claim 7, wherein the pits are formed such that, if an average distance between one pit and other six pits which are closest to the one pit is P, a distance between the one pit and each of the other six pits adjacent to the one pit is in the range of 0.9P-1.2P.

14. The method for manufacturing a patterned member according to claim 8, wherein the scanning step comprises scanning the substrate with the electromagnetic beam along a single spiral track formed by the plurality of tracks, so that the plurality of pits are arranged in line along the spiral track.

15. The method for manufacturing a patterned member according to claim 8, wherein the scanning step comprises scanning the substrate with the electromagnetic beam along a plurality of circles having different diameters, so that the plurality of pits are arranged in line on the plurality of circles.
